# EUROPEAN PATENT SPECIFICATION

(11) **EP 0 394 493 B1**
(45) Date of publication and mention of the grant of the patent: **25.10.1995**
(21) Application number: 89911616.4
(22) Date of filing: 24.10.1989
(51) Int. Cl.: H04B 14/04, H04B 14/06

(54) **AUDIO SIGNAL DEMODULATION CIRCUIT**
DEMODULATORSCHALTUNG FÜR AUDIOSIGNALE
CIRCUIT DEMODULATEUR DE SIGNAUX AUDIO

(30) Priority: 24.10.1988 JP 267452/88
(43) Date of publication of application: 31.10.1990
(73) Proprietor: MATSUSHITA ELECTRIC INDUSTRIAL CO., LTD., Kadoma-shi, Osaka-fu, 571 (JP); NIPPON HOSO KYOKAI, Tokyo 150 (JP)
(72) Inventor: MIYOSHI, Toshihiro, Osaka-shi, Osaka 551 (JP); OKUMURA, Naoji, Ibaragi.shi, Osaka 567 (JP); ARITA, Hisashi, Kawabe-gun, Hyogo 662-02 (JP); ISHIKAWA, Kenji, Hirakata-shi, Osaka 573 (JP); NINOMIYA, Yuichi, Kawasaki-shi, Kanagawa 215 (JP); OTSUKA, Yoshimichi, Kawasaki-shi, Kanagawa 214 (JP); KAWASHIMA, Tadashi, Tokyo 152 (JP); IWAMOTO, Takushi, Matsuyama-shi, Ehime 790 (JP)
(74) Representative: Votier, Sidney David
(86) International application number: JP8901089
(87) International publication number: WO9004891

(56) References cited:
- EP-A- 0 264 986
- JP-A- 5 348 452
- JP-A- 5 750 308
- JP-A- 6 024 740
- JP-A- 6 135 632
- JP-U-60 101 843
- US-A- 4 567 591
- PATENT ABSTRACTS OF JAPAN vol. 011, no. 130 (E-502)23 April 1987

## Description

### SPECIFICATION

### AUDIO SIGNAL DEMODULATION CIRCUIT

### TECHNICAL FIELD

The present invention relates to an audio signal demodulation circuit for use in a high definition television ("high vision") receiver, or the like.

### BACKGROUND ART

The high definition television ("high vision") intends to provide new charms such as forceful and attendant feelings which cannot be obtained by the existing television broadcasting; these charms are given by display of a high definition television image on a large-scale wide screen and digital PCM sound.

As a method for band-compressing a high definition television signal, the MUSE (Multiple Sub-Nyquist Sampling Encoding) system has been proposed by Nippon Hoso Kyokai (NHK) (Y. Ninomiya et al "KOHINI TEREBI NO EISEI 1 CHANNEL DENSO HOSIKI" SINGAKURONSI Vol. J68 - D. No. 4 PP. 647 - 654 (1985); WATANABE, TAKEHARA "HIVISION ONSEI BASE BAND DENSO YO JUNSHUNJIASSIN DPCM HOSIKI" DENSI-JOHO-TSUSIN GAKKAI (Sho 62 March)).

Referring to the drawings, one example of the conventional audio signal demodulation circuits will be explained.

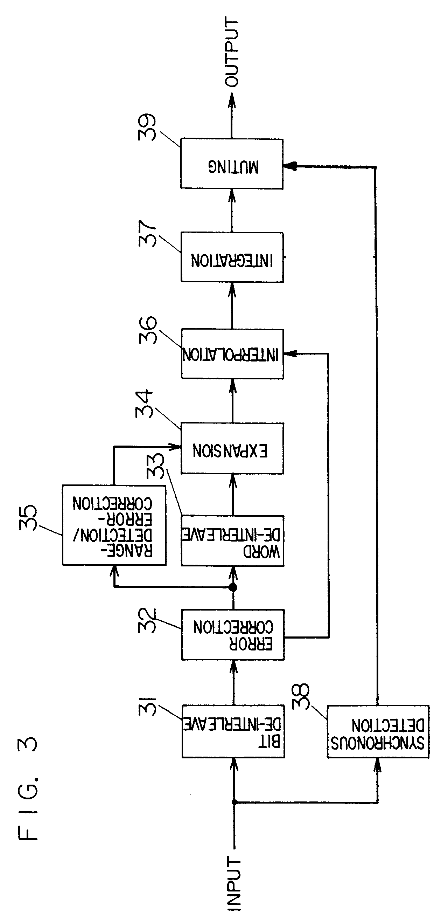

Figs. 3, 4 and 5 are a block diagram of the conventional audio signal demodulation circuit, a timing chart thereof and a waveform chart thereof, respectively. In Fig. 3, 31 is a bit de-interleave circuit; 32 is an error correction circuit; 33 is a word de-interleave circuit; 34 is an expansion circuit; 35 is a range detection/error correction circuit; 36 is an interpolation circuit; 37 is an integration circuit; 38 is a synchronous detection circuit; and 39 is a muting circuit.

The operation of the audio signal demodulation circuit thus constructed will be explained with reference to Figs. 3, 4 and 5.

First, an audio input signal at 1350 kb/s is detected in its synchronization pattern by the synchronous detection circuit 38 to take synchronization. The output (synchronization lock signal) from the synchronous detection circuit 38 is applied to the muting circuit 39 so that it is at a high level if the synchronization has been taken while it is at a low level if the synchronization has not been taken.

Also the input audio signal is cancelled in its interleave performed on the transmission side by the bit de-interleave circuit 31. The output from the bit de-interleave circuit 31 is error-corrected by the error correction circuit 32 so that one-error correction two error detection is made in the normal mode and two-error correction three-error detection is made in the intensifying mode. The signal subjected to the two-error detection in the normal mode and the three-error detection in the intensifying mode will be used as an interpolation signal in the interpolation circuit 36.

The output from the error correction circuit 32 is cancelled in its word interleave performed on the transmission side by the word de-interleave circuit 33.

The output from the error correction circuit 32 is also detected in its range bits and error-detected by the range detection/error correction circuit 35.

The outputs from the word de-interleave circuit 33 is expanded by the expansion circuit 34 in accordance with the range bits detected by the range detection/ error correction circuit 35.

The output from the expansion circuit 34 is subjected to the average value interpolation or the previous value interpolation by the previous sample value in the same channel using an interpolation signal output from the error correction circuit 32; a differential value is produced from the interpolation circuit 36. The differential value output from the interpolation circuit 36 is integrated by the integration circuit 37. If the synchronization lock signal output from the synchronous detection circuit 38 is at a low level owing to synchronization unlock, forcible muting or the like, the output from the muting circuit 39 is extracted as an audio signal at the low level.

The operation of the integration circuit 37 and the muting circuit 39 will be explained in further detail.

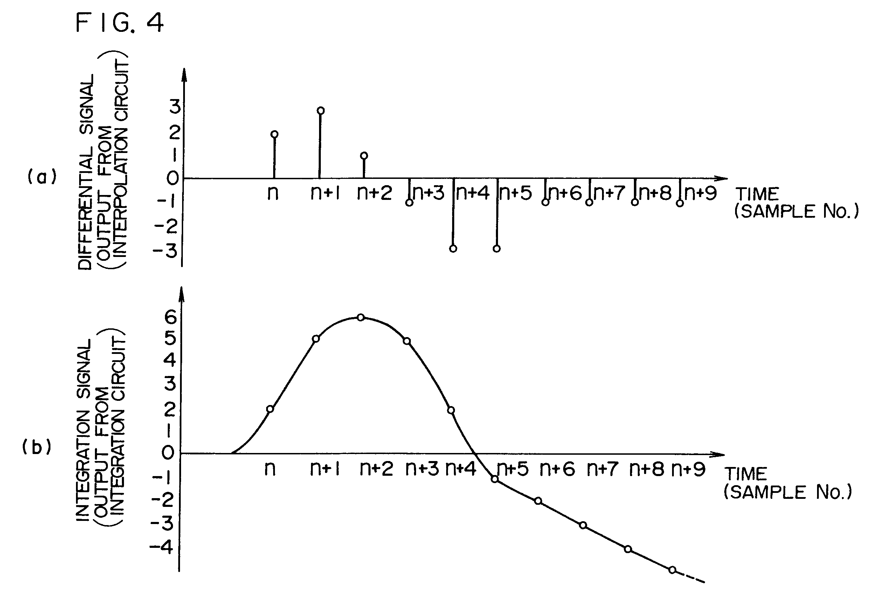

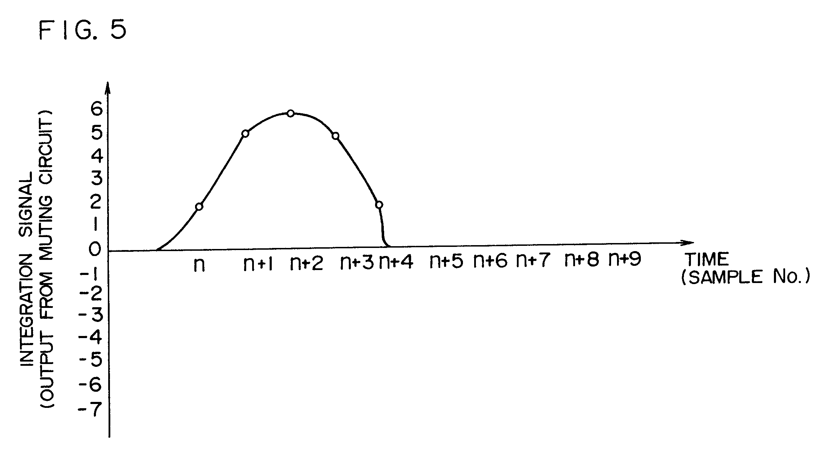

Now, it is assumed that the differential signal output from the interpolation circuit 36 has the values as shown in (a) of Fig. 4 (for simplicity of illustration, only the values for the same channel in two or four channels are shown). In (a) of Fig. 4, the abscissa represents time (sample No.) and the ordinate represents the differential signal output from the interpolation circuit 36. For example, the differential signal is 2 at time n and it is 3 at time n + 1. The output from the integration circuit 37 is obtained by adding the differential value at the time at issue to the integrated value at the previous sampling time. Now, if the output from the integration circuit 37 is muted at time n + 4 by the forcible muting, it is placed in the low level at time n + 3 as shown in Fig. 5.

However, in the above arrangement, the audio signal is abruptly removed in the cases where the synchronization has been lost or the forcible muting is done so that noise 'puff' will be produced.

### DISCLOSURE OF INVENTION

An object of the invention is to provide an audio signal demodulating circuit which can demodulate suitable sound for audiences without producing noise "puff' even if synchronization has been lost or forcible muting is done.

In order to attain the above object, the audio signal demodulating circuit according to the present invention comprises a synchronous detection circuit and a muting circuit for muting the output from an interpolation circuit using a synchronization lock signal produced from the synchronous detection circuit when synchronization has been lost.

In accordance with the above arrangement, the differential signal output from interpolation circuit is muted by the muting circuit using the synchronization lock signal at a low level output from the synchronous detection circuit so that sound free from noise can be produced even when synchronization has been lost or forcible muting is done.

### BRIEF DESCRIPTION OF DRAWINGS

Fig. 1 is a block diagram of the audio signal demodulation circuit according to an embodiment of the present invention;
Figs. 2(a) and 2(b) are waveform charts for explaining the operation of the audio signal demodulation circuit;
Fig. 3 is a block diagram of the conventional audio signal demodulation circuit; and
Figs. 4(a) and 4(b) and Fig. 5 are waveform charts for explaining the operation of the audio signal demodulation circuit.

### DESCRIPTION OF THE PREFERRED EMBODIMENT

Referring to the drawings, explanation will be given for an embodiment of the audio signal demodulation circuit according to the present invention.

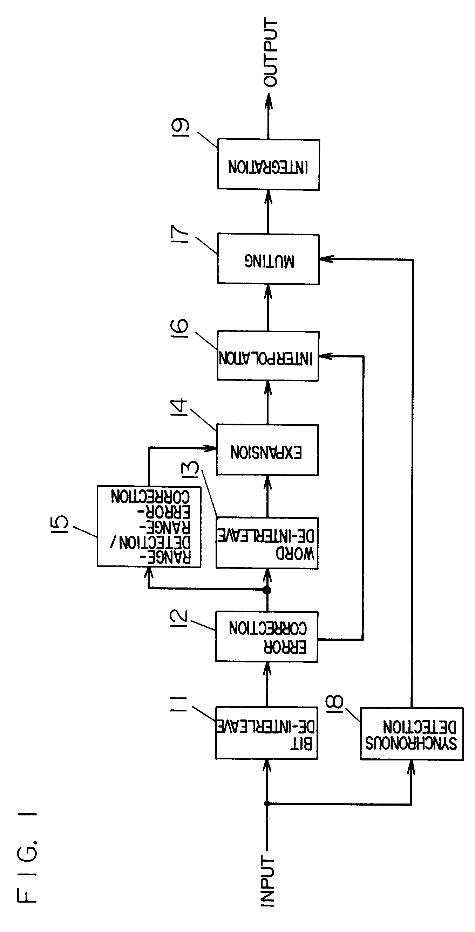

Fig. 1 is a block diagram of the audio signal demodulation circuit according to an embodiment of the present invention.

In Fig. 1, 11 is a bit de-interleave circuit; 12 is an error correction circuit; 13 is a word de-interleave circuit; 14 is an expansion circuit; 15 is a range detection/error correction circuit; 16 is an interpolation circuit; 17 is a muting circuit; 18 is a synchronous detection circuit; and 19 is an integration circuit.

The arrangement of Fig. 1 is different from the prior art arrangement of Fig. 4 in that the muting circuit 17 is located in front of the integration circuit 19.

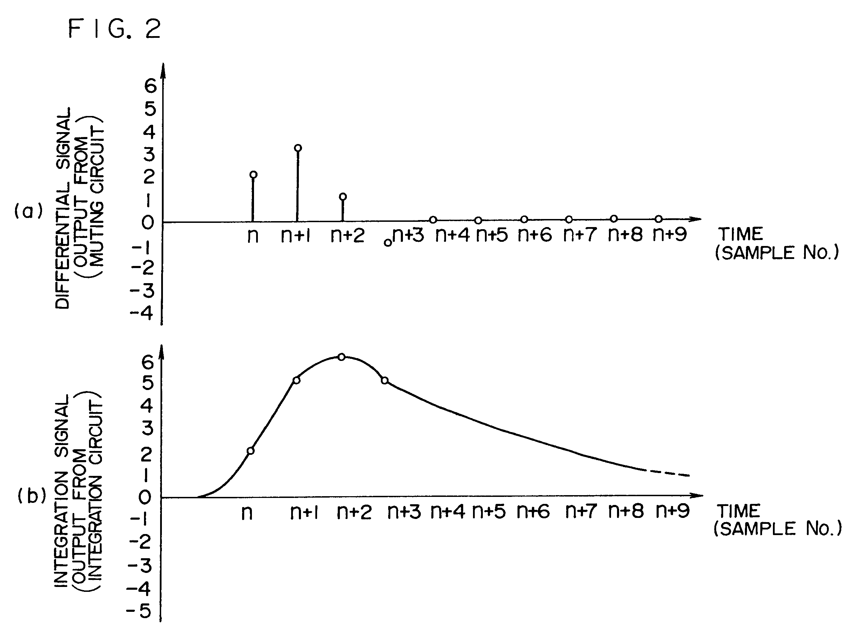

The operation of the audio signal demodulation circuit thus constructed will be explained with reference to Figs. 1 and 2.

First, an audio input signal at 1350 kb/s is detected in its synchronization pattern by the synchronous detection circuit 18 to take synchronization. The output (synchronization lock signal) from the synchronous detection circuit 18 is applied to the muting circuit 17 so that it is at a high level if the synchronization has been taken while it is at a low level if the synchronization has not been taken.

Also the input audio signal is cancelled in its interleave performed on the transmission side by the bit de-interleave circuit 11. The output from the bit de-interleave circuit 11 is error-corrected by the error correction circuit 12 so that one-error correction two error detection is made in the normal mode and two-error correction three-error detection is made in the intensifying mode. The signal subjected to the two-error detection in the normal mode and the three-error detection in the intensifying mode will be used as an interpolation signal in the interpolation circuit 16.

The output from the error correction circuit 12 is cancelled in its word interleave performed on the transmission side by the word de-interleave circuit 13.

The output from the error correction circuit 12 is also detected in its range bits and error-detected by the range detection/error correction circuit 15.

The output from the word de-interleave circuit 13 is expanded by the expansion circuit 14 in accordance with the range bits detected by the range detection/ error correction circuit 15.

The output from the expansion circuit 14 is subjected to the average value interpolation or the previous value interpolation by the previous sample value in the same channel using an interpolation signal output from the error correction circuit 12; a differential value is produced from the interpolation circuit 16.

In only the case where the synchronization lock signal output from said synchronous detection circuit 18 is at a low level (owing to synchronization unlock, forcible muting, or the like), the differential signal output from the interpolation circuit 16 is placed in the low level by the muting circuit 17; in the other cases, the differential signal is passed through the muting circuit 17 as it is. The differential signal output from the muting circuit 17 is integrated to be demodulated as an audio signal.

The operation of the muting circuit 17 and the integration circuit 19 will be explained in further detail. It is assumed as in the prior art that the differential signal output from the interpolation circuit 16 has the values as shown in Fig. 4(a) (the abscissa represents time (sample No.) and the ordinate represents the differential signal output from the interpolation circuit 16). As seen from Fig. 2(a), the differential signal is 2 at time n, and it is 3 at time n + 1. When the differential signal is muted owing to forcible muting at time n + 4, it is made zero by the muting circuit 17 during the forcible muting at time n + 4 et seq. as shown in Fig. 2(a). The differential signal thus obtained from the muting circuit 17 will be integrated by the integration circuit 19. The output from the integration circuit 19, which is multiplied by the leak coefficient less than 1 in order to lessen deterioration of sound quality due to transmission error, will be attenuated gradually as shown in Fig. 2(b).

In accordance with the embodiment, the differential signal output from the interpolation circuit 16 is made zero by the muting circuit 17 so that sound can be outputted without producing noise such as 'puff' even when synchronization has been lost or forcible muting is done.

Accordingly, in accordance with the present invention, the differential signal output from the interpolation circuit is muted by the muting circuit and thereafter integrated by the integration circuit so that sound can be outputted without producing noise even when synchronization has been lost or forcible muting is done.

## Claims

1. An audio signal demodulation circuit comprising:
a bit de-interleave circuit (11) for canceling the bit interleave of an input audio signal performed on the transmission side;
an error correction circuit (12) for error-correcting the output from the bit de-interleave circuit (11);
a word de-interleave circuit (13) for canceling the word interleave of the first output signal from said error correction circuit (12) performed on the transmission side;
a range-detection/error-correction circuit (15) for range-detecting and range-error-correcting the first output signal from said error correction circuit (12);
an expansion circuit (14) for expanding the output from said word de-interleave circuit (13) in accordance with the range bits output from said range-detection/error-correction circuit (15);
an interpolation circuit (16) for interpolating the output from said expansion circuit (14) using an interpolation signal which is the second output from said error correction circuit;
a synchronous detection circuit (18) for synchronization-detecting said input audio signal;
a muting circuit (17) for muting the output from said interpolation circuit using the output generated from said synchronous detection circuit (18) when synchronization has been lost; and
an integration circuit (19) for integrating the output from said muting circuit (17) to be outputted as sound.

## Patentansprüche

1. Audiosignaldemodulationsschaltung mit:
einer Bit-Entschachtelungsschaltung (11) zum Aufheben der auf der Übertragungsseite ausgeführten Bit-Verschachtelung eines Eingangsaudiosignals;
einer Fehlerkorrekturschaltung (12) zum Fehlerkorrigieren des Ausgangssignals aus der Bit-Entschachtelungsschaltung (11);
einer Wortentschachtelungsschaltung (13) zum Aufheben der auf der Übertragungsseite aufgeführten Wortverschachtelung des ersten Ausgangssignals aus der Fehlerkorrekturschaltung (12);
einer Bereichserfassungs/Fehlerkorrekturschaltung (15) zum Erfassen und Bereich-Fehler-Korrigieren des ersten Ausgangssignals aus der Fehlerkorrekturschaltung (12);
einer Expansionsschaltung (14) zum Expandieren des Ausgangssignals aus der Wortentschachtelungsschaltung (13) entsprechend der von der Bereichserfassungs/Fehlerkorrekturschaltung (15) ausgegebenen Bereichs-Bits;
einer Interpolationsschaltung (16) zum Interpolieren des Ausgangssignals aus der Expansionsschaltung (14) unter Verwendung eines Interpolationssignals, das das zweite Ausgangssignal aus der Fehlerkorrekturschaltung ist;
einer Synchronisationserfassungsschaltung (18) zur Synchronisationserfassung des Eingangsaudiosignals;
einer Stummschaltschaltung (17) zum Stummschalten des Ausgangssignals aus der Interpolationsschaltung unter Verwendung des von der Synchronisationserfassungsschaltung (18) erzeugten Ausgangssignals, wenn die Synchronisation verloren worden ist; und
einer Integrationsschaltung (19) zum Integrieren des Ausgangssignals aus der Rauschunterdrückungsschaltung (17) zur Ausgabe als Klang.

## Revendications

1. Circuit de démodulation de signal audio, comprenant:
un circuit (11) de démultiplexage numérique pour annuler le multiplexage numérique d'un signal audio en entrée, effectué du côté émission;
un circuit (12) de correction d'erreurs pour corriger les erreurs du signal de sortie du circuit (11) de démultiplexage numérique;
un circuit (13) de démultiplexage de mots pour annuler le multiplexage de mots du premier signal de sortie dudit circuit (12) de correction d'erreurs, effectué du côté émission;
un circuit (15) de détection de plage/correction d'erreurs pour détecter la plage et corriger les erreurs de plage du premier signal de sortie dudit circuit (12) de correction d'erreurs;
un circuit (14) d'expansion pour produire l'expansion du signal de sortie dudit circuit (13) de démultiplexage de mots conformément au bits de plage délivrés par ledit circuit (15) de détection de plage/correction d'erreurs;
un circuit (16) d'interpolation pour interpoler le signal de sortie dudit circuit (14) d'expansion en utilisant un signal d'interpolation qui est le second signal de sortie dudit circuit de correction d'erreurs;
un circuit (18) de détection synchrone pour détecter la synchronisation dudit signal audio en entrée;
un circuit (17) d'amortissement pour amortir le signal de sortie dudit circuit d'interpolation en utilisant le signal de sortie émis par ledit circuit (18) de détection synchrone lorsque la synchronisation a été perdue; et
un circuit (19) d'intégration pour intégrer le signal de sortie dudit circuit (17) d'amortissement qui doit être délivré en tant que son.
